# EUROPÄISCHE PATENTSCHRIFT

(11) **EP 0 903 014 B1**
(45) Veröffentlichungstag und Bekanntmachung des Hinweises auf die Patenterteilung: **08.08.2001**
(21) Anmeldenummer: 97925874.6
(22) Anmeldetag: 26.05.1997
(51) Int. Cl.: H03K 17/95, H01R 13/66

(54) **NÄHERUNGSSCHALTER MIT MECHANISCHER ENTKOPPLUNG VON ANSCHLUSSSTIFTEN UND STECKEREINSATZ**
PROXIMITY SWITCH WITH MECHANICAL DECOUPLING OF TERMINAL PINS AND PLUG-IN UNIT
COMMUTATEUR DE PROXIMITE A DECOUPLAGE MECANIQUE DE BROCHES DE CONTACT ET DE DISPOSITIF ENFICHABLE

(30) Priorität: 05.06.1996 DE 19622445
(43) Veröffentlichungstag der Anmeldung: 24.03.1999
(73) Patentinhaber: SIEMENS AKTIENGESELLSCHAFT, 80333 München (DE)
(72) Erfinder: BÄUML, Alfred, D-92442 Wackersdorf (DE); SCHMITT, Manfred, D-92256 Hahnbach (DE); GASSNER, Robert, D-93051 Regensburg (DE)
(86) Internationale Anmeldenummer: DE9701066
(87) Internationale Veröffentlichungsnummer: WO9747087

(56) Entgegenhaltungen:
- WO-A-93/15554
- DE-U- 9 200 772
- DE-U- 9 302 714

## Beschreibung

Die Erfindung bezieht sich auf einen Näherungsschalter, mit einem Gehäuse, mit einem Sensorelement, z.B. einem Schalenkern mit einer Sensorspule, mit einer Leiterplatte, die in einer Vergußmasse im Gehäuse eingebettet und einerseits mit dem Sensorelement und andererseits mit Anschlußstiften elektrisch bzw. mechanisch verbunden ist und auf ein Verfahren zur Herstellung eines Mäherungsschalters.

Ein gattungsgemäßer Näherungsschalter ist z.B. aus dem deutschen Gebrauchsmuster DE 92 00 772 U1 bekannt. Bei diesem ist das hülsenförmige Gehäuse in Höhe einer zentral angeordneten Leuchtdiode mit mehreren Bohrungen versehen, um den Schaltzustand des Näherungsschalters nach allen Seiten hin sichtbar zu machen. Als Lichtleiter von der Leuchtdiode zu den Bohrungen hin dient ein durchsichtiger Steckereinsatz, der bis vor die Bohrungen reicht. Der Steckereinsatz ist mit Anschlußstiften fest verbunden, deren Enden nach Kröpfung direkt mit der Leiterplatte elektrisch in Verbindung stehen. Die Steckerstifte mit gekröpften Enden können direkt auf die Leiterplatte aufgelötet sein.

DE 93 02 714 U offenbart einen Mäherungsschalter mit Sensorelement und Leiterplatte, wobei die Anschlußstifte sowohl durch eine direkte mechanische Verbindung mit der Leiterplatte als auch durch einen Kontaktträger und einen Schutzkragen gehalten sind.

Der Erfindung liegt die Aufgabe zugrunde einen Näherungsschalter der obengenannten Art zu schaffen, der ohne Übertragung von Kräften über die Leiterplatte auf das Sensorelement montierbar ist. Weiterhin ist es Aufgabe der Erfindung ein entsprechendes Herstellungsverfahren anzugeben.

Die Aufgabe wird dadurch gelöst, daß die Anschlußstifte, abgesehen von der Vergußmasse, lediglich durch eine direkte mechanische Verbindung mit der Leiterplatte gehalten sind und daß ein im Gehäuse integrierter Steckereinsatz die Anschlußstifte umgibt, ohne für diese eine Halterungsfunktion auszuüben.

Vorteilhafte Weiterbildungen der Erfindung sind den Unteransprüchen 2 bis 7 zu entnehmen,.

Eine vorteilhafte Ausführungsform besteht, wenn die Leiterplatte mit den Anschlußstiften und mit dem Sensorelement zusammen als baueinheitlicher Schalteinsatz ausgeführt ist, der in dem Gehäuse, abgesehen von der Vergußmasse, sich lediglich über das Sensorelement abstützt. Diese Ausführung erweist sich als besonders montagefreundlich, da der Schalteinsatz sich leicht vorfertigen läßt und dann der Einsatz als Baueinheit wesentlich erleichtert ist.

Weiterhin ist es vorteilhaft, wenn der Steckereinsatz zur Führung der Lötstifte bei der Montage dienende Führungsmittel aufweist. Auch diese technische Maßnahme erleichtert die Montage. Zweckmäßigerweise sind die Führungsmittel als Nasen mit Bohrungen mit einem gegenüber der Dicke der Anschlußstifte größeren Bohrungsdurchmesser ausgeführt.

Besteht die Einbettung des Schalteinsatzes in einer nur durch einen einzigen Verguß des Gehäuses geschaffenen Vergußmasse in dem Gehäuse, so wird auf diese Weise der Montage- und damit auch der Kostenaufwand reduziert.

Um eine Schaltzustandsanzeige mit einer Leuchtdiode über eine im Gehäuse vorgesehene Öffnung zu ermöglichen, besteht der Steckereinsatz zumindest teilweise aus transparentem Material.

Außerdem ist es vorteilhaft, wenn der Steckereinsatz eine umlaufende Dichtung aufweist, die einen Spalt zum Gehäuse derart abdichtet, daß sie einen Ausfluß von Vergußmasse über Öffnungen zur Zustandsanzeige verhindert.

Die weitere Aufgabe zur Bereitstellung eines Herstellungsverfahrens für einen Näherungsschalter der oben beschriebenen Art wird durch folgende Verfahrensschritte gelöst:

Ein zylindrisches Gehäuse, dessen eine Endöffnung durch eine Kappe abgedeckt ist, wird mit Vergußmasse soweit ausgegossen, daß ein definierter Zwischenraum zwischen einer zur Schaltzustandsanzeige dienenden Öffnung im Gehäuse freibleibt, in die nicht ausgehärtete Vergußmasse wird ein baueinheitlich aus einer Leiterplatte, Anschlußstiften sowie einem Sensorelement, z.B. einem Schalenkern mit einer Sensorspule, zusammengefügter Schalteinsatz eingeführt, wobei die Vergußmasse zum Teil zu der Öffnung hin verdrängt wird, ein an seinem Boden teilweise offener Steckereinsatz wird in das Gehäuse unter Verdrängung von Vergußmasse eingeführt, wobei dies zumindest teilweise den Zwischenraum zwischen dem Steckereinsatz und der Innenwand des Gehäuses ausfüllt.

Das Verfahren wird vorteilhaft verbessert, wenn sich der Schalteinsatz nach Einführen in die nicht ausgehärtete Vergußmasse über das Sensorelement an der Kappe lediglich mit dem Eigengewicht abstützt. Dies hat zur Folge, daß keine weiteren, möglicherweise zerstörerisch wirkenden Kräfte auf das Sensorelement, z.B. den Schalenkern, einwirken.

Ein Ausführungsbeispiel der Erfindung wird im folgenden anhand einer Zeichnung näher erläutert. Es zeigen:
- FIG 1: einen baueinheitlich zusammengefügten Schalteinsatz,
- FIG 2: ein mit einer Kappe einseitig abgedecktes zylindrisches Gehäuse für einen Näherungsschalter, das teilweise mit Vergußmasse ausgefüllt ist,
- FIG 3: ein zylindrisches Gehäuse gemäß FIG 2 in das ein Schalteinsatz gemäß FIG 1 eingeführt ist,
- FIG 4: einen Teilschnitt durch das Gehäuse im Anschlußbereich mit Darstellung von Anschlußstiften und einem Steckereinsatz, die teilweise in der Vergußmasse eingebettet sind,
- FIG 5: eine Schnittdarstellung des Steckereinsatzes gemäß FIG 4 und
- FIG 6: eine Unteransicht des Steckereinsatzes gemäß FIG 5.

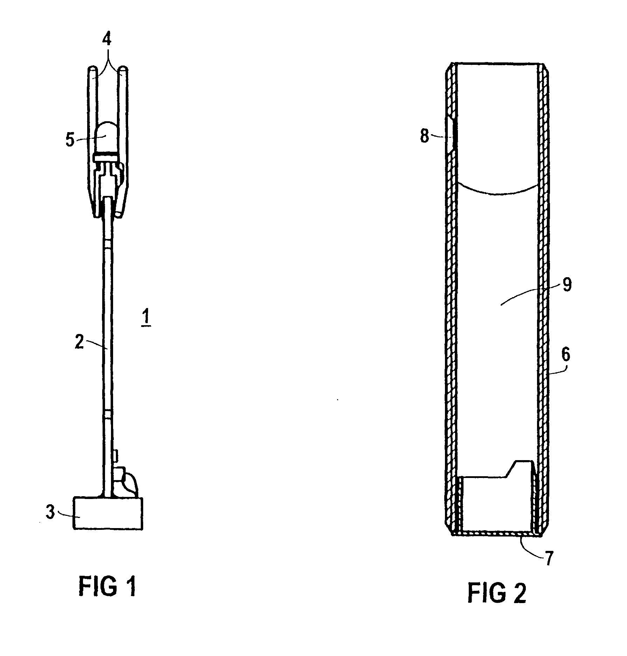

Der erfindungsgemäße Näherungsschalter, insbesondere ein induktiver Näherungsschalter, umfaßt einen in FIG 1 dargestellten Schalteinsatz 1. Dieser ist im wesentlichen aus einer Leiterplatte 2, einem Schalenkern 3 mit einer Sensorspule als Sensorelement auf der einen Seite und Lötstiften 4 und einer Leuchtdiode 5 auf der anderen Seite zusammengesetzt.

FIG 2 zeigt ein zylindrisches Gehäuse eines erfindungsgemäßen Näherungsschalters, dessen eine Endöffnung durch eine Kappe 7 dicht abgeschlossen ist. Das Gehäuse 6 ist bis auf einen definierten Zwischenraum zu einer Öffnung 8 für eine Schaltzustandsanzeige mit einer Vergußmasse 9 ausgefüllt.

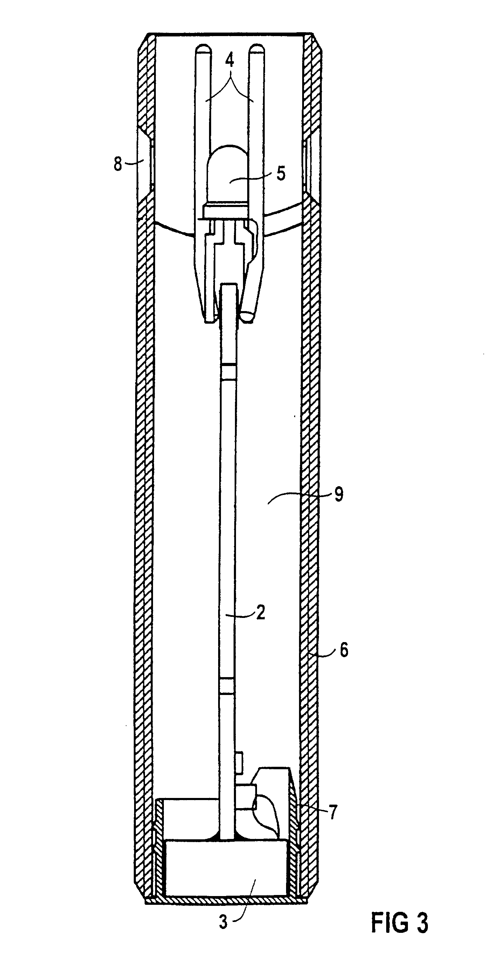

In FIG 3 ist der Schalteinsatz 1 gemäß FIG 1 in der Vergußmasse 9 eingebettet dargestellt, wobei sich der Schalenkern 3 an der Kappe 7 abstützt und erst nach Aushärtung der Vergußmasse zusätzlich noch durch diese gehalten ist. Bei der Einführung des Schalteinsatzes 1 in die Vergußmasse 9 wird diese zur Öffnung 8 hin verdrängt wie es in der FIG 3 angedeutet ist.

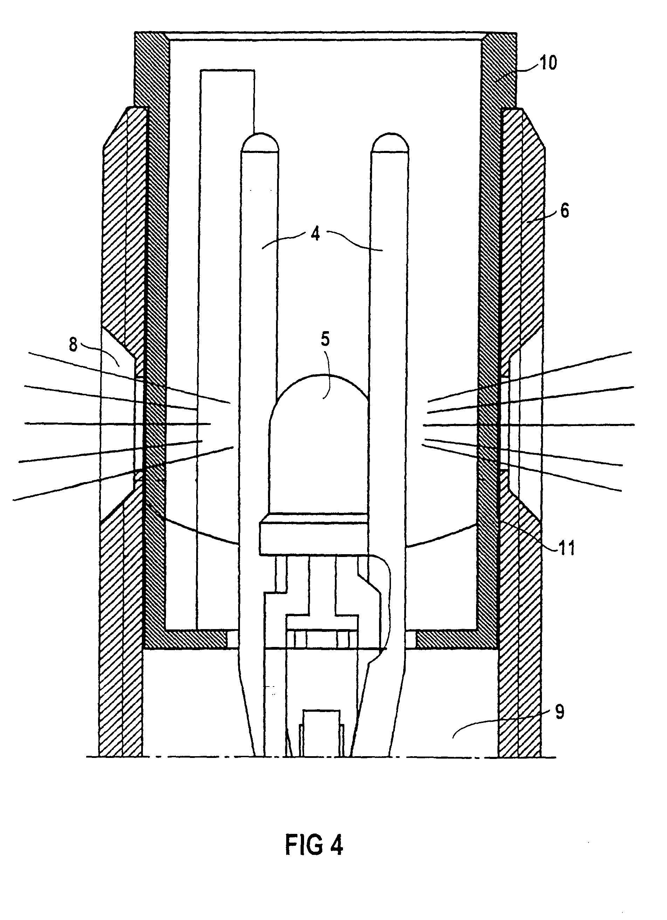

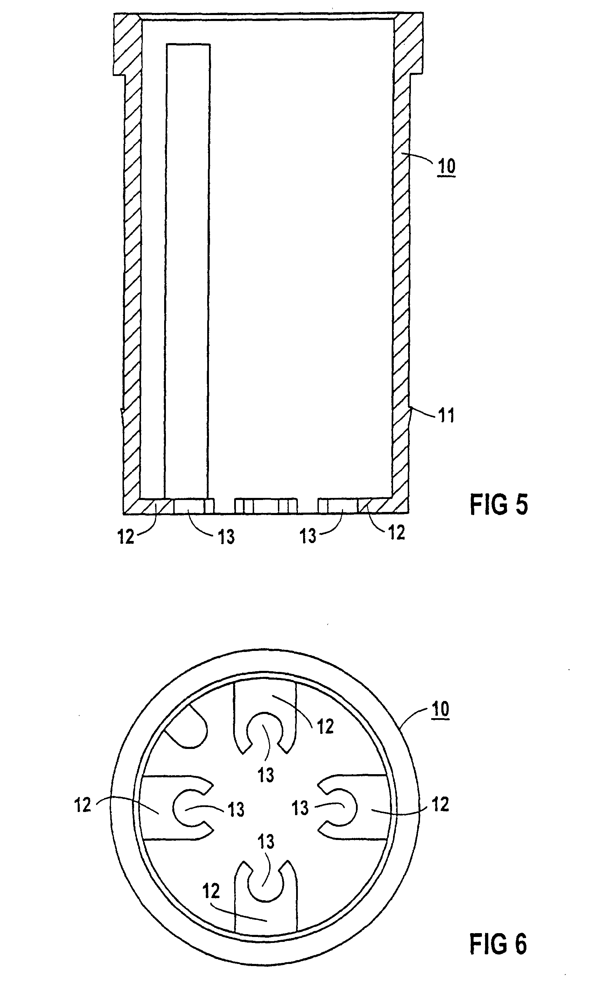

In FIG 4 ist der Anschlußbereich des Gehäuses 6 dargestellt, wobei gegenüber der FIG 3 die Veränderung darin besteht, daß zusätzlich in das zylindrische Gehäuse 6 ein Steckereinsatz 10 geschoben ist. Dieser weist gemäß FIG 5 eine umlaufende Dichtung in Form einer Schaberippe 11 auf, welche den Ausfluß von Vergußmasse 9 durch die Öffnung 8 für die Zustandsanzeige verhindert. Der Steckereinsatz 10 ist an seiner Unterseite mit vier Nasen 12 mit Halbbohrungen 13 zur Führung der Anschlußstifte 4 versehen. Die vier Nasen 12 sichern in Verbindung mit der hochsteigenden Vergußmasse 9 im Steckerinnenraum den Steckereinsatz 10 gegen Zug- und Torsionskräfte.

Die Leuchtdiode 5 liegt außerhalb der Vergußmasse 9, so daß diese nicht notwendigerweise transparent sein muß. Es ist lediglich ein zur Öffnung 8 hin teilweise transparenter Steckereinsatz 10 erforderlich, um die Schaltzustandsanzeige durch die Leuchtdiode 5 zu gewährleisten.

Das erfindungsgemäße Herstellungsverfahren des oben beschriebenen Näherungsschalters ist in seinen einzelnen Schritten den FIG 1 bis 4 zu entnehmen. Der baueinheitlich zusammengefügte Schalteinsatz 1 gemäß FIG 1 wird in das mit Vergußmasse 9 ausgefüllte zylindrische Gehäuse 6 eingeführt. Nach Einführung wird der Schalteinsatz 1 über seinen Schalenkern 3 an der Kappe 7 im Gehäuse 6 gehalten wie es FIG 3 zu entnehmen ist. Die Grenzfläche der Vergußmasse 9 hebt sich aufgrund der Verdrängung durch den Schalteinsatz 1 zur Öffnung 8 hin an. Anschließend wird der Steckereinsatz 10 gemäß FIG 5 und 6 in das zylindrische Gehäuse 6 eingeführt, wobei die Anschlußstifte 4 über Halbbohrungen 13 am Steckereinsatz 10 geführt werden. Die Schaberippe 11 drängt ebenfalls Vergußmasse 9 an der Innenwand des Gehäuses 6 zurück und verhindert somit den Austritt von Vergußmasse 9 durch die Öffnung 8.

Die Montage des Näherungsschalters zeichnet sich dadurch aus, daß keine Kräfte über die elektrische Schaltung, d.h. über die Leiterplatte 2 auf den Schalenkern 3, übertragen werden. Dies wird dadurch erreicht, daß die Anschlußstifte 4 nicht durch den Steckereinsatz 10 sondern durch die Leiterplatte 2 gehalten werden. Somit wird eine Entkopplung der mechanischen Verbindung zwischen den Steckereinsatz 10 und den Anschlußstiften 4 erreicht. Ein weiterer wesentlicher Vorteil besteht darin, daß bei dem Herstellungsverfahren nunmehr nur noch ein einmaliger Verguß erforderlich ist.

Obwohl die vorliegende Erfindung unter Bezugnahme auf die in der beigefügten Zeichnung dargestellte Ausführungsform erläutert ist, sollte berücksichtigt werden, daß damit nicht beabsichtigt ist, die Erfindung nur auf die dargestellte Ausführungsform zu beschränken, sondern alle möglichen Änderungen, Modifizierungen und äquivalente Anordnungen, soweit sie vom Inhalt der Patentansprüche gedeckt sind, einzuschließen.

## Patentansprüche

1. Näherungsschalter, insbesondere induktiver Näherungsschalter, mit einem Gehäuse (6), mit einem Sensorelement (3), z.B. ein Schalenkern mit einer Sensorspule, mit einer Leiterplatte (2), die in einer Vergußmasse (9) im Gehäuse (6) eingebettet und einerseits mit dem Sensorelement (3) und andererseits mit Anschlußstiften (4) elektrisch bzw. mechanisch verbunden ist, wobei die Anschlußstifte (4), abgesehen von der Vergußmasse (9), lediglich durch eine direkte mechanische Verbindung mit der Leiterplatte (2) gehalten sind und daß ein im Gehäuse (6) integrierter Steckereinsatz (10) die Anschlußstifte (4) umgibt, ohne für diese eine Halterungsfunktion auszuüben.

2. Näherungsschalter nach Anspruch 1, **dadurch gekennzeichnet**, daß die Leiterplatte (2) mit den Anschlußstiften (4) und mit dem Sensorelement (3), zusammen als baueinheitlicher Schalteinsatz (1) ausgeführt ist, der in dem Gehäuse (6), abgesehen von der Vergußmasse (9), sich lediglich über das Sensorelement (3) abstützt.

3. Näherungsschalter nach Anspruch 1 oder 2, **dadurch gekennzeichnet**, daß der Steckereinsatz (10) zur Führung der Anschlußstifte (4) bei der Montage dienende Führungsmittel (12,13) aufweist.

4. Näherungsschalter nach Anspruch 3, **dadurch gekennzeichnet**, daß die Führungsmittel als Nasen (12) mit Bohrungen (13) ausgeführt sind mit einem gegenüber der Dicke der Anschlußstifte (4) größeren Bohrungsdurchmesser.

5. Näherungsschalter nach einem der vorangehenden Ansprüche, **dadurch gekennzeichnet**, daß die Einbettung des Schalteinsatzes (1) in einer nur durch einen einzigen Verguß des Gehäuses (6) geschaffenen Vergußmasse (9) in dem Gehäuse (6) besteht.

6. Näherungsschalter nach einem der vorangehenden Ansprüche, **dadurch gekennzeichnet**, daß der Steckereinsatz (10) zumindest teilweise aus transparentem Material besteht.

7. Näherungsschalter nach einem der vorangehenden Ansprüche, **dadurch gekennzeichnet**, daß der Steckereinsatz (10) eine umlaufende Dichtung (11) aufweist, die einen Spalt zum Gehäuse (6) derart abdichtet, daß sie einen Ausfluß von Vergußmasse (9) über Öffnungen (8) zur Zustandsanzeige verhindert.

8. Verfahren zur Herstellung eines Näherungsschalter gemäß einem der Ansprüche 1 bis 7, **gekennzeichnet** durch folgende Schritte:
a) ein zylindrisches Gehäuse (6), dessen eine Endöffnung durch eine Kappe (7) abgedeckt ist, wird mit Vergußmasse (9) so weit ausgegossen, daß ein definierter Zwischenraum zwischen einer zur Schaltzustandsanzeige dienenden Öffnung (8) im Gehäuse (6) frei bleibt,
b) in die nicht ausgehärtete Vergußmasse (9) wird ein baueinheitlich aus einer Leiterplatte (2), Anschlußstiften (4) sowie einem Sensorelement (3), z.B. einem Schalenkern mit einer Sensorspule, zusammengefügter Schalteinsatz (1) eingeführt, wobei die Vergußmasse (9) zum Teil zu der Öffnung (8) hin verdrängt wird und
c) ein an seinem Boden teilweise offener Steckereinsatz (10) wird in das Gehäuse (6) unter Verdrängung von Vergußmasse (9) eingeführt, wobei diese zumindest teilweise den Zwischenraum zwischen dem Steckereinsatz (10) und der Innenwand des Gehäuses (6) ausfüllt.

9. Verfahren nach Anspruch 8, **dadurch gekennzeichnet,** daß sich der Schalteinsatz (1) nach Einführen in die nicht ausgehärtete Vergußmasse (9) über das Sensorelement (3) an der Kappe (7) abstützt.

## Claims

1. A proximity switch, in particular an inductive proximity switch, comprising a housing (6), a sensor element (3), for example a pot core containing a sensing coil, and a printed circuit board (2) which is embedded in a casting compound (9) in the housing (6) and is on the one hand connected electrically and mechanically to the sensor element (3) and on the other hand to the connecting pins (4), with the connecting pins (4) being held - leaving aside the casting compound (9) - only by a direct mechanical connection to the printed circuit board, and with a connector insert (10) incorporated in the housing (6) and surrounding the connecting pins (4) without performing a supporting function for them.

2. Proximity switch in accordance with Claim 1,
**characterised in that** the printed-circuit board (2) is combined with the connecting pins (4) and the sensor element (3) into a constructional module forming a switching insert (1), said switching insert being supported in the housing (6) - leaving aside the casting compound (9) - by the sensor element (3) only.

3. Proximity switch in accordance with Claim 1 or 2,
**characterised in that** the connector insert (10) is provided with guiding means (12, 13) for the purpose of guiding the connecting pins (4) during assembly.

4. Proximity switch in accordance with Claim 3,
**characterised in that** the guiding means are designed as protrusions (12) having holes (13) with a hole diameter greater than the thickness of the connecting pins (4).

5. Proximity switch in accordance with one of the preceding claims,
**characterised in that** the embedding of the switching insert (1) in the casting compound (9) in the housing (6) is performed in one single casting operation.

6. Proximity switch in accordance with one of the preceding claims,
**characterised in that** the connector insert (10) consists at least partially of a transparent material.

7. Proximity switch in accordance with one of the preceding claims,
**characterised in that** the connector insert (10) is provided around its circumference with a seal (11) which seals the gap to the housing (6) such that it prevents the casting compound (9) from flowing out of the openings (8) for the state indication.

8. Method for manufacturing a proximity switch in accordance with one of the claims 1 to 7, **characterised** by the following steps:
a) a cylindrical housing (6), one end opening of which is closed off by a cap (7), is filled up with a casting compound (9) to a level that leaves a defined spacing in the housing (6) between the casting compound and an opening (8) used for indicating the switched state,
b) before the casting compound (9) hardens, a switching insert (1), consisting of a constructional module formed by a printed-circuit board (2), connecting pins (4) and a sensor element (3) (e.g. a pot core with a sensing coil), is introduced into the casting compound (9), partially displacing the casting compound (9) in the direction of the opening (8), and
c) a connector insert (10), partially open at its lower end, is then introduced into the housing (6), thereby displacing some of the casting compound (9), and the latter at least partially filling the space between the connector insert (10) and the inner wall of the housing (6).

9. Method in accordance with Claim 8,
**characterised in that** the switching insert (1), after its introduction into the not yet hardened casting compound (9), is supported (via the sensor element (3)) on the cap (7).

## Revendications

1. Commutateur de proximité, notamment commutateur inductif de proximité, comprenant un boîtier (6), un élément (3) formant capteur, par exemple un noyau en forme de coquille ayant une bobine de capteur, une plaquette (2) à circuit imprimé qui est enrobée dans le boîtier (6) dans une composition (9) de scellement et qui est reliée électriquement et mécaniquement d'une part à l'élément (3) formant capteur et d'autre part à des broches (4) de raccordement, les broches (4) de raccordement étant maintenues indépendamment de la composition (9) de scellement seulement par une liaison mécanique directe avec la plaquette (2) à circuit imprimé et en ce qu'un dispositif enfichable intégré dans le boîtier (6) entoure les broches (4) de raccordement sans exercer pour celles-ci une fonction de maintien.

2. Commutateur de proximité suivant la revendication 1, caractérisé en ce que la plaquette (2) à circuit imprimé est exécutée ensemble avec les broches (4) de raccordement à l'élément (3) formant capteur sous la forme d'un insert (1) formant une unité de construction qui est soutenue dans le boîtier (6), indépendamment de la composition (9) de scellement, seulement par l'élément (3) formant capteur.

3. Commutateur de proximité suivant la revendication 1 ou 2, caractérisé en ce que le dispositif (10) enfichable comporte des moyens (12, 13) de guidage servant à guider les broches (4) de raccordement pendant le montage.

4. Commutateur de proximité suivant la revendication 3, caractérisé en ce que les moyens de guidage sont constitués en becs (12) ayant des trous (13) avec un diamètre des trous plus grand que l'épaisseur des broches (4) de raccordement.

5. Commutateur de proximité suivant l'une des revendications précédentes, caractérisé en ce que l'incorporation de l'insert dans le boîtier (6) s'effectue dans une composition (9) de scellement ménagée par une seule coulée.

6. Commutateur de proximité suivant l'une des revendications précédentes, caractérisé en ce que le dispositif (10) enfichable est au moins partiellement en une matière transparente.

7. Commutateur de proximité suivant l'une des revendications précédentes, caractérisé en ce que le dispositif (10) enfichable comporte une garniture (11) d'étanchéité qui fait le tour, qui rend étanche un intervalle vis à vis du boîtier (6) de manière à empêcher toute sortie de la composition (9) de scellement par des ouvertures (8) destinées à indiquer un état.

8. Procédé de fabrication d'un commutateur de proximité suivant l'une des revendications 1 à 7, caractérisé par les stades suivants :
a) on coule un boîtier (6) cylindrique, dont une ouverture d'extrémité est recouverte d'un chapeau (7), d'une composition (9) de scellement jusqu'à ce qu'il subsiste dans le boîtier (6) un intervalle défini entre une ouverture (8) servant à indiquer l'état de commutation,
b) dans la composition (9) de scellement qui n'est pas encore durcie est introduit un insert (1) constitué en une unité de construction d'une plaquette (2) à circuit imprimé, de broches (4) de raccordement ainsi que d'un élément (3) formant capteur, par exemple d'un noyau en forme de coquille, ayant une bobine de capteur, la composition (9) de scellement étant refoulée en partie vers l'ouverture (8) et
c) un dispositif (10) enfichable ouvert partiellement sur son fond est introduit dans le boîtier (6) en refoulant de la composition (9) de scellement, celle-ci remplissant au moins partiellement l'intervalle compris entre le dispositif (10) enfichable et la paroi intérieure du boîtier (6).

9. Procédé suivant la revendication 8, caractérisé en ce que l'insert (1) est soutenu après introduction dans la composition (9) de scellement qui n'a pas encore durci sur le chapeau (7) par l'élément (3) formant capteur.
